# EUROPEAN PATENT APPLICATION

(11) **EP 4 431 342 A1**
(43) Date of publication of application: **18.09.2024**
(21) Application number: 22892792.7
(22) Date of filing: 09.11.2022
(51) Int. Cl.: B60R 16/02, F16J 15/10, H05K 5/04, H05K 5/06, H02G 3/08, H02G 3/14, H02G 3/16

(54) **VEHICULAR ELECTRONIC DEVICE AND PRODUCTION METHOD THEREFOR**

(30) Priority: 11.11.2021 JP 2021183899
(71) Applicant: Valeo Japan Co., Ltd., Kumagaya-Shi SAITAMA 360-0193 (JP)
(72) Inventor: NOSE, Toshimitsu, Kumagaya-shi Saitama 360-0193 (JP)
(74) Representative: Valeo Systèmes Thermiques
(86) International application number: PCT/JP2022/041629
(87) International publication number: WO 2023/085294

(57) **Abstract**

To increase the service life of a vehicular electronic device without increasing the thicknesses of a housing and a cover. The vehicular electronic device (20; 20B) includes a sealing member (50; 50B) sandwiched between a housing (30) and a cover (40) and configured to prevent dust from entering into an internal space (Sp). The sealing member (50; 50B) includes: a first sealing region (51; 51B) formed over an entire circumference so as to be sandwiched between an edge of the opening (31) and an edge of the cover (40); a second sealing region (52; 52B) formed so as to be continuous from an end portion of the first sealing region (51; 51B) and adhered to an outer circumferential surface of the housing (30); and a third sealing region (53; 53B) formed so as to be continuous from an end portion of the first sealing region (51; 51B) and adhered to an outer circumferential surface of the cover.

## Description

### Technical Field

The present invention relates to a vehicular electronic device which is placed in an equipment placement room and operated by being energized.

### Background Art

In many vehicles, a vehicular electronic device which is operated by being energized is placed in an equipment placement room. As the related art pertaining to a vehicular electronic device, there are techniques disclosed in Patent Documents 1 and 2.

Patent Document 1 discloses, as a vehicular electronic device, a fluid heating device that heats a fluid with a heater. Patent document 2 discloses an electric compressor as a vehicular electronic device used in an air conditioner.

These vehicular electronic devices are similar to each other in that the vehicular electronic devices include a housing in which an internal space including an opening is formed and a circuit board is accommodated, a cover that covers the opening of the housing, and a sealing member that is sandwiched between the housing and the cover and prevents dust and the like from entering into the housing.

### Citation List

### Patent Literature

Patent Document 1: JP2017-72293A
Patent Document 2: JP2015-17577A

### Summary of Invention

### Technical Problem

Some vehicular electronic devices are provided in an equipment placement room (for example, a vehicle front compartment in which an engine and a radiator are placed) partitioned separately from a passenger compartment configured to accommodate a passenger. Water splashed from a puddle or the like on a road surface may be scattered inside the equipment placement room. When the housing or the cover of a vehicular electronic device is made of metal, such water causes rust. From the viewpoint of extending a product life, it is desired to suppress the rust from spreading to the inner circumferential surface of the housing or the cover.

That is, it is desired to provide a vehicular electronic device that can achieve a long service life.

An object of the invention is to provide a vehicular electronic device that can achieve a long service life.

### Solution to Problem

In the following description, for the purpose of facilitating the understanding about the invention, reference signs in the accompanying drawings are described in parentheses, but the invention is not limited to the configurations illustrated in the drawings.

According to an aspect of the present disclosure, there is provided a vehicular electronic device provided in an equipment placement room (12) partitioned separately from a passenger compartment (11) configured to accommodate a passenger, the vehicular electronic device including:
a housing (30) made of metal and formed with an internal space (Sp) including an opening (31);
a circuit board (22) accommodated in the internal space (Sp) and configured to be energized;
a cover (40) made of metal and configured to cover the opening (31); and
a sealing member (50; 50B) sandwiched between the housing (30) and the cover (40) and configured to prevent dust from entering into the internal space (Sp),
the sealing member (50; 50B) including
   a first sealing region (51; 51B) formed over an entire circumference so as to be sandwiched between an edge of the opening (31) and an edge of the cover (40),
   a second sealing region (52; 52B) formed so as to be continuous from an end portion of the first sealing region (51; 51B) and adhered to an outer circumferential surface of the housing (30), and
   a third sealing region (53; 53B) formed so as to be continuous from an end portion of the first sealing region (51; 51B) and adhered to an outer circumferential surface of the cover.

According to another aspect of the present disclosure, there is provided a method for producing a vehicular electronic device which is provided in an equipment placement room (12) partitioned separately from a passenger compartment (11) configured to accommodate a passenger and is operated by being energized, the method including:
a preparation step of preparing
   a housing (30) made of metal and formed with an internal space (Sp) including an opening (31),
   a circuit board (22) configured to be energized, and
   a cover (40) made of metal;
a circuit board accommodation step of accommodating the circuit board (22) in the internal space (Sp), the circuit board accommodation step being a step after the preparation step;
a sealing material application step of applying a sealing material to an edge of the opening (31) and/or an edge of the cover (40), the sealing material application step being a step after the circuit board accommodation step;
a sealing material sandwiching step of sandwiching the sealing material (62) between the edge of the opening (31) and the edge of the cover (40) caused to face each other, the sealing material sandwiching step being a step after the sealing material application step; and
a sealing step of performing sealing by pressing the sealing material (62) protruded from between the edge of the opening (31) and the edge of the cover (40) in the sealing material sandwiching step against outer circumferential surfaces of the housing (30) and the cover (40).

### Advantageous Effects of Invention

According to the invention, a vehicular electronic device that can achieve a long service life can be provided.

### Brief Description of Drawings

[FIG. 1] FIG. 1 is a schematic diagram of a vehicle mounted with a vehicular electronic device according to Example 1.
[FIG. 2] FIG. 2 is a perspective view of the vehicular electronic device illustrated in FIG. 1.
[FIG. 3] FIG. 3 is an exploded perspective view of the vehicular electronic device illustrated in FIG. 2.
[FIG. 4] FIG. 4 is a cross-sectional view taken along a 4-4 line in FIG. 2.
[FIG. 5] 5A is a diagram illustrating a plasma surface treatment step, 5B is a diagram illustrating a masking step, 5C is a diagram illustrating a circuit board accommodation step, 5D is a diagram illustrating a sealing material application step, 5E is a diagram illustrating a sealing material sandwiching step, 5F is a diagram illustrating a sealing step, and 5G is a diagram illustrating a masking removal step.
[FIG. 6] 6A is a diagram illustrating problems in a vehicular electronic device according to Comparative Example 1, 6B is a diagram illustrating problems in a vehicular electronic device according to Comparative Example 2, and 6C is a diagram illustrating problems in a vehicular electronic device according to Example.
[FIG. 7] FIG. 7 is a cross-sectional view of a vehicular electronic device according to Example 2.

### Description of Embodiments

Embodiments of the invention will be described below with reference to the accompanying drawings.

### <Example 1>

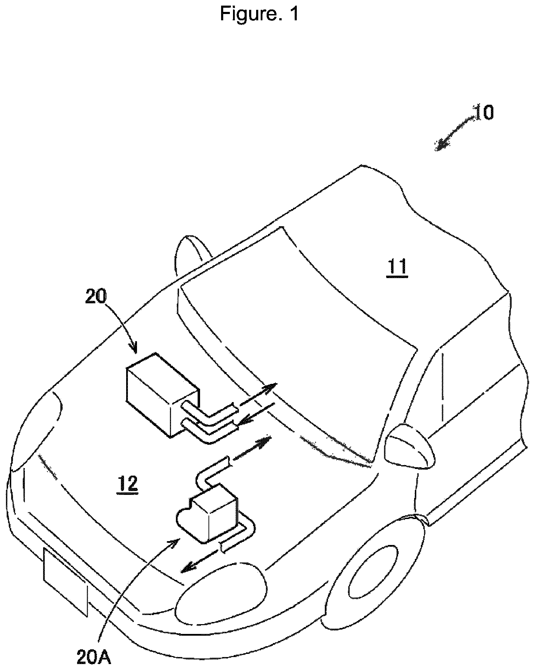

Refer to FIG. 1. FIG. 1 illustrates a vehicle 10. The vehicle 10 is, for example, a passenger vehicle and includes a passenger compartment 11 configured to accommodate a passenger and an equipment placement room 12 provided in front of the passenger compartment 11 and partitioned by a partition wall (not illustrated). The equipment placement room 12 is, for example, an engine room and accommodates an engine, vehicular electronic devices 20 and 20A, and the like.

The vehicular electronic devices 20 and 20A are, for example, a liquid heating device and an electric compressor. Hereinafter, the vehicular electronic device 20 (hereinafter, abbreviated as the "electronic device 20") as a liquid heating device will be described as an example. However, the electronic device 20A as an electric compressor is the same in the configuration of a main part, and thus detailed descriptions thereof will be omitted.

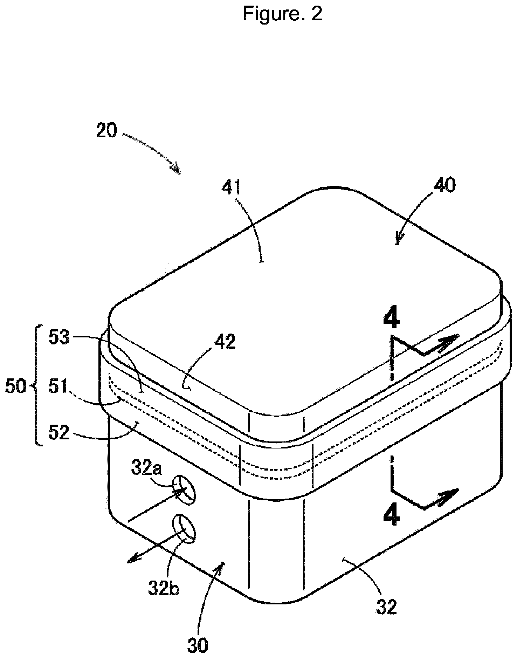

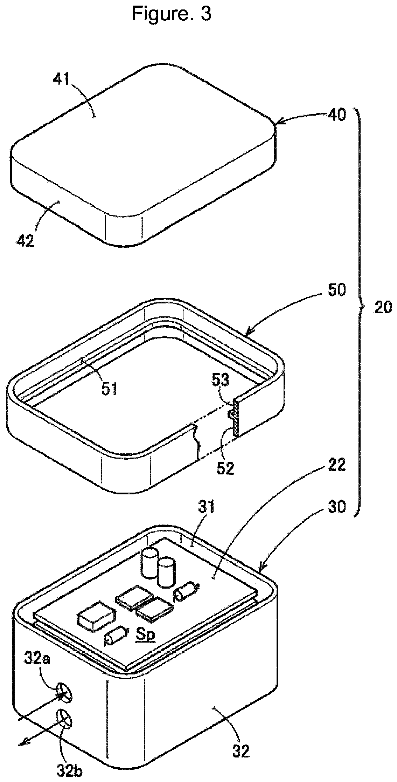

Refer to FIG. 2 and FIG. 3. The electronic device 20 is a device for heating circulating water. Heated water is fed to a heating heat exchanger disposed in the passenger compartment 11 (see FIG. 1) and used as a heat source for heating the interior of the passenger compartment 11.

The electronic device 20 includes; a housing 30 which is made of metal and which includes an internal space Sp including an opening 31 at an upper surface (a housing 30 made of metal and formed with an internal space Sp including an opening 31 at an upper surface); a circuit board 22 accommodated in the internal space Sp and configured to be energized; a cover 40 made of metal and configured to cover the opening 31; and a sealing member 50 sandwiched between the housing 30 and the cover 40 and configured to prevent dust from entering into the internal space Sp.

The housing 30 has a substantially cuboid shape opening at an upper surface. The housing 30 is made of, for example, an aluminum alloy. The housing 30 is formed with a circuit board accommodation internal space (not illustrated) accommodating the circuit board 22 and a heater accommodation internal space (not illustrated) which is partitioned separately from the circuit board accommodation internal space and in which a heater for heating water is accommodated.

The housing 30 includes a housing side surface portion 32 formed in a substantially rectangular tube shape. The opening 31 is a portion surrounded by an upper end of the housing side surface portion 32. An introduction port 32a for introducing water into the heater accommodation internal space and a discharge port 32b for discharging heated water are opened in the housing side surface portion 32.

As the circuit board 22, for example, a printed circuit board formed by printing a circuit on a surface of a glass substrate can be used. The heater can heat circulating water by being operated via the circuit board 22.

The cover 40 is made of an aluminum alloy. The cover 40 includes a cover main body 41 which has the substantially same shape as the opening 31 of the housing 30 and covers the internal space Sp, and a cover side surface portion 42 extending from a circumferential edge of the cover main body 41 toward an edge of the opening 31 of the housing 30 (the housing side surface portion 32).

The lower end of the cover side surface portion 42 faces the upper end of the housing side surface portion 32.

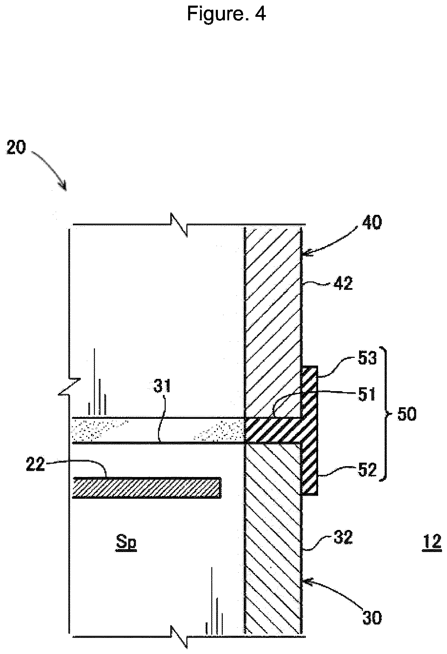

Refer to FIG. 3 and FIG. 4. The sealing member 50 is made of, for example, two-component silicone rubber. More specifically, Silastic W3-3636, which is a sealant made by Dow Chemical, can be used.

The sealing member 50 has a shape in which a substantially T-shaped cross section continuously makes a round. The sealing member 50 includes: a first sealing region 51 formed over an entire circumference so as to be sandwiched between an edge of the opening 31 and an edge of the cover 40; a second sealing region 52 formed so as to be continuous from an end portion of the first sealing region 51 and adhered to an outer circumferential surface of the housing 30; and a third sealing region 53 formed so as to be continuous from an end portion of the first sealing region 51 and adhered to an outer circumferential surface of the cover 40. The first sealing region 51, the second sealing region 52, and the third sealing region 53 are integrally formed of a single member.

The thickness of the second sealing region 52 and the thickness of the third sealing region 53 are thinner than the thickness of the first sealing region 51. The reason therefor will be described below. Similar to the first sealing region 51, the second sealing region 52 and the third sealing region 53 are formed over the entire circumference.

A method for producing the electronic device 20 described above, in particular, a method for forming the sealing member 50 will be described below.

First, the housing 30 made of metal and formed with the internal space Sp including the opening 31, the circuit board 22 that can be energized, and the cover 40 made of metal are prepared (preparation step).

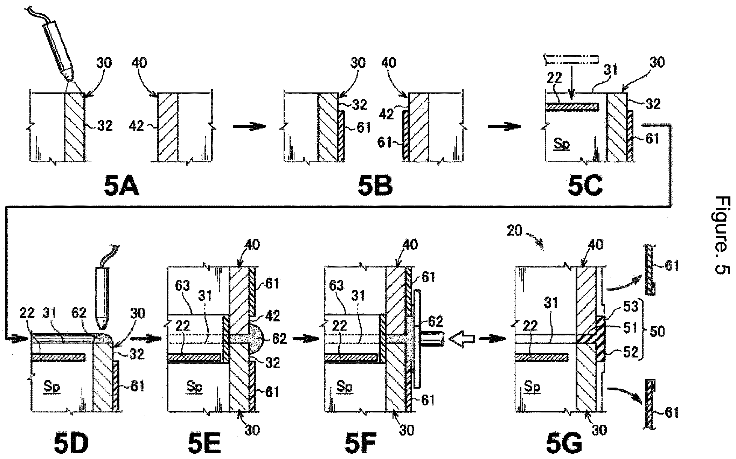

Refer to FIG. 5A. Next, plasma treatment is performed on the surface of the prepared housing 30 and the surface of the prepared cover 40 (plasma surface treatment step). The plasma treatment is surely performed on, in particular, a leading end of the housing side surface portion 32 and a leading end of the cover side surface portion 42, in addition to the opening 31 of the housing 30 and a surface of the cover 40 facing the opening 31. As the plasma treatment and a device necessary for the plasma treatment, a known device and a known method can be used.

By performing the plasma treatment, oil and fat components and dust adhering to the surfaces of the housing and the cover can be removed, and the metal surfaces can be activated so that the chemical bonding force with the sealing member 50 is increased. This can increase corrosion resistance.

Refer to FIG. 5B. Next, masking is performed on the outer circumferential surface of the housing 30 and the outer circumferential surface of the cover 40 which have been subjected to the plasma treatment (masking step). For example, the masking is performed by attaching masking tapes 61 and 61 on the outer circumferential surface of the housing 30 and the outer circumferential surface of the cover 40, respectively.

Refer to FIG. 5C. Next, the circuit board 22 is accommodated in the internal space Sp of the housing 30 (circuit board accommodation step).

Refer to FIG. 5D. A sealing material 62 is applied to an edge of the opening 31 of the housing 30 in which the circuit board 22 is accommodated (sealing material application step). The sealing material 62 can be said to be a material of the sealing member 50 (see FIG. 3) which becomes the sealing member 50 by being cured. The sealing material 62 has a certain fluidity.

The sealing material application step may be performed on only the leading end of the housing side surface portion 32, or may be performed on both of the leading end of the housing side surface portion 32 and the leading end of the cover side surface portion 42. Alternatively, this step may be performed on only the leading end of the cover side surface portion 42.

Refer to FIG. 5E. Next, the edge of the cover 40 is caused to face the edge of the opening 31 and the sealing material 62 is sandwiched between these edges (sealing material sandwiching step). In performing the sealing member sandwiching step, a shield member 63 may be disposed on an inner circumferential surface side so as to prevent leakage of the sealing material 62 to the inner circumferential surface side. A certain amount of the sealing material 62 leaks out on an outer circumferential surface side.

Refer to FIG. 5F. The sealing material 62 leaked out from between the housing 30 and the cover 40 by being sandwiched is pressed against the outer circumferential surfaces of the housing 30 and the cover 40 and left until cured. When the sealing material 62 is cured, sealing between the housing 30 and the cover 40 is achieved (sealing step) .

Refer to FIG. 5G. After the sealing material 62 is cured to be the sealing member 50, the masking tapes 61 and 61 are removed (masking removal step). Accordingly, the electronic device 20 is completed.

The electronic device 20 will be summarized below.

Refer to FIG. 1. The electronic device 20 is provided in the equipment placement room 12 partitioned separately from the passenger compartment 11 configured to accommodate a passenger. Refer to FIG. 3. The electronic device 20 includes; the housing 30 made of metal and formed with the internal space Sp including the opening 31; the circuit board 22 accommodated in the internal space Sp and configured to be energized; the cover 40 made of metal and configured to cover the opening 31; and the sealing member 50 sandwiched between the housing 30 and the cover 40 and configured to prevent dust from entering into the internal space Sp. Refer also to FIG. 4. The sealing member 50 includes: a first sealing region 51 formed over an entire circumference so as to be sandwiched between an edge of the opening 31 and an edge of the cover 40; a second sealing region 52 formed so as to be continuous from an end portion of the first sealing region 51 and adhered to an outer circumferential surface of the housing 30; and a third sealing region 53 formed so as to be continuous from an end portion of the first sealing region 51 and adhered to an outer circumferential surface of the cover 40.

Refer to FIG. 5. The method for producing the electronic device 20 includes: the preparation step of preparing the housing 30 made of metal and formed with the internal space Sp including the opening 31, the circuit board 22 configured to be energized, and the cover 40 made of metal; the circuit board accommodation step of accommodating the circuit board 22 in the internal space Sp, the circuit board accommodation step being a step after the preparation step; the sealing material application step of applying the sealing material 62 to an edge of the opening 31 and/or an edge of the cover 40, the sealing material application step being a step after the circuit board accommodation step; the sealing material sandwiching step of sandwiching the sealing material 62 between the edge of the opening 31 and the edge of the cover 40 caused to face each other, the sealing material sandwiching step being a step after the sealing material application step; and the sealing step of performing sealing by pressing the sealing material 62 protruded from between the edge of the opening 31 and the edge of the cover 40 in the sealing material sandwiching step against outer circumferential surfaces of the housing 30 and the cover 40.

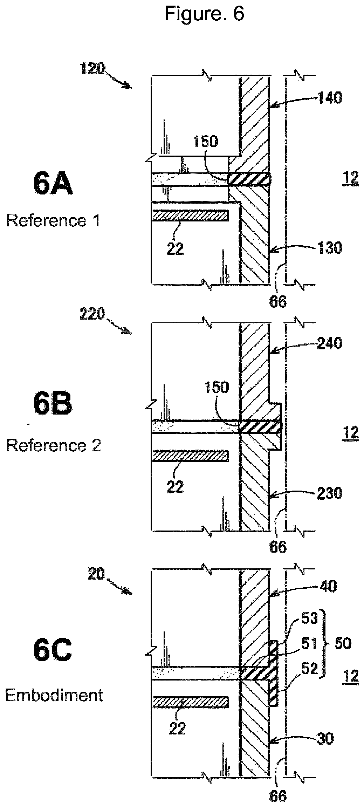

Refer to FIG. 6A. FIG. 6A illustrates an electronic device 120 according to Comparative Example 1. Water or the like scattering from the outside of the vehicle into the equipment placement room 12 may adhere to the outer circumferential surface of a housing 130 and a cover 140. The attached water may cause rust, and the rust may be spread through between the housing 130 and a sealing member 150 or through between the cover 140 and the sealing member 150 to the inside of the housing 130 or the cover 140. In this situation, in order to increase a time until the rust is spread to the inner circumferential surface of the housing 130 or the cover 140, it is conceivable to extend an edge of the housing 130 or an edge of the cover 140 toward an inner circumferential surface side. In this case, a distance between the circuit board 22 accommodated in the housing 130 and the housing 130 is reduced. When the circuit board 22 comes close to the housing 130, unintended electrical discharge may occur, and an electronic circuit may not operate properly. Further, in order to manufacture the housing 130 or the cover 140 whose edge is extended to the inner circumferential side, a complicated mold is required, and a manufacturing cost is increased.

Refer to FIG. 6B. FIG. 6B illustrates an electronic device 220 according to Comparative Example 2. In order to increase a time until rust is spread to the inner circumferential surface of a housing 230 or a cover 240, it is conceivable to extend an edge of the housing 230 or an edge of the cover 240 toward an outer circumferential surface side in contrast to the case of FIG. 6A. Many devices such as a device 66 are provided inside the equipment placement room 12 in which the electronic device 220 is provided. The vehicle 10 mounted with the electronic device 220 vibrates during traveling. For this reason, when the edge of the housing 230 or the edge of the cover 240 is extended to the outer circumferential surface side, the possibility of interference between the electronic device 220 and other devices such as the device 66 is increased due to vibration, which is not preferable.

Next, refer to FIG. 6C. FIG. 6C illustrates the electronic device 20 according to Example. The sealing member 50 includes: the second sealing region 52 formed so as to be continuous from an end portion of the first sealing region 51 and adhered to an outer circumferential surface of the housing 30; and the third sealing region 53 formed so as to be continuous from an end portion of the first sealing region 51 and adhered to an outer circumferential surface of the cover 40. By forming the second sealing region 52 and the third sealing region 53, it is possible to prevent water from the outside of the vehicle from adhering to the vicinities of the edge of the housing 30 and the edge of the cover 40. This can increase a time until rust is spread from the outer circumferential surfaces to the inner circumferential surfaces of the housing 30 and the cover 40. The service life of the vehicular electronic device 20 can be increased without increasing the thicknesses of the housing 30 and the cover 40.

Refer to FIG. 5. The second sealing region 52 and the third sealing region 53 can be formed by pressing the sealing material 62 protruded from between the edge of the opening 31 and the edge of the cover 40 in the sealing material sandwiching step (see 5E) against the outer circumferential surfaces of the housing 30 and the cover 40 (the sealing step, see 5F). This is preferable because the second sealing region 52 and the third sealing region 53 can be easily formed.

Refer to FIG. 6C. The first sealing region 51, the second sealing region 52, and the third sealing region 53 are integrally formed of a single member. By integrally forming the first sealing region 51 to the third sealing region 53 with a single member, it is possible to eliminate boundary portions between the respective sealing regions and increase the corrosion resistance.

The thickness of the second sealing region 52 and the thickness of the third sealing region 53 are thinner than the thickness of the first sealing region 51. By making the thicknesses of the second sealing region 52 and the third sealing region 53 thinner, it is possible to prevent interference with other devices such as the device 66 and increase the service life of the electronic device 20. Further, by making the thickness of the second sealing region 52 and the thickness of the third sealing region 53 thinner, the curing time of the sealing material 61 in these regions can be reduced.

Refer to FIG. 5. In producing the electronic device 20, a plasma surface treatment step of irradiating the edge of the opening 31 and the edge of the cover 40 with plasma (see 5A) can be performed before the circuit board accommodation step. By preliminarily performing the plasma surface treatment step, it is possible to increase the adherence of the sealing member 50 and improve the corrosion resistance.

### <Example 2>

Next, an electronic device 20B according to Example 2 will be described with reference to the drawing. The same parts as those in Example 1 are denoted by the same reference signs, and the detailed descriptions thereof will be omitted.

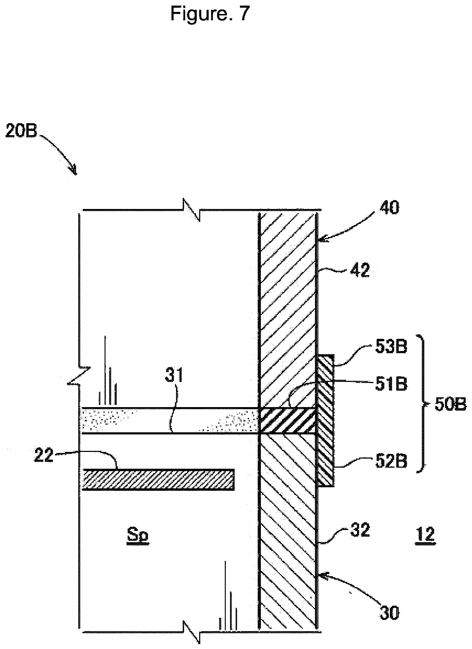

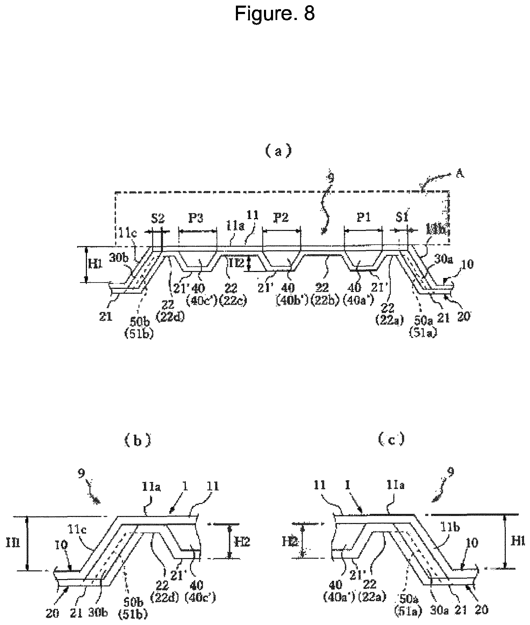

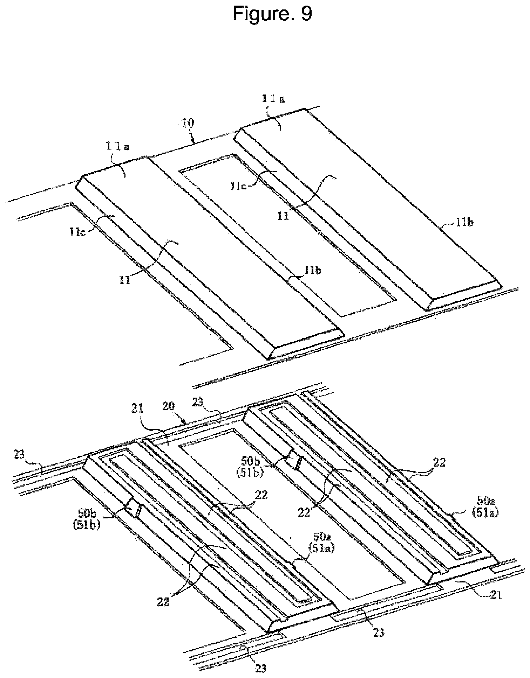

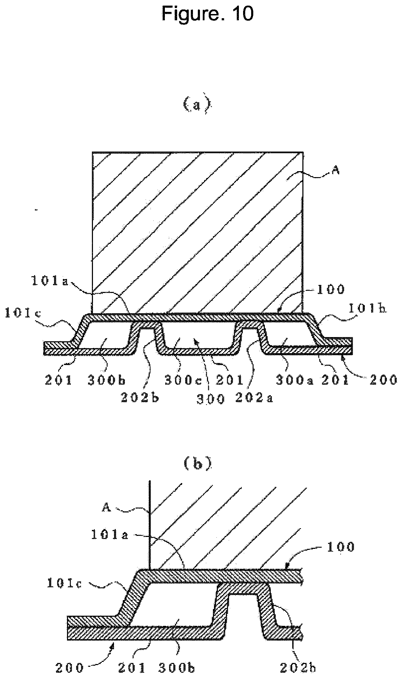

FIG. 7 illustrates a cross-sectional configuration of the electronic device 20B according to Example 2. A sealing member 50B of the electronic device 20B according to Example 2 includes two members. That is, a member constituting a first sealing region 51B and a member constituting a second sealing region 52B and a third sealing region 53B are different from each other.

It should be noted that the first sealing region 51B and the second sealing region 52B may be made of the same material and only the third sealing region 53B may be made of a different material, or the first sealing region 51B and the third sealing region 53B may be made of the same material and only the second sealing region 52B may be made of a different material.

The sealing member 50B includes: the first sealing region 51B formed over an entire circumference so as to be sandwiched between an edge of the opening 31 and an edge of the cover 40; the second sealing region 52B formed so as to be continuous from an end portion of the first sealing region 51B and adhered to an outer circumferential surface of a housing 30B; and the third sealing region 53B formed so as to be continuous from an end portion of the first sealing region 51B and adhered to an outer circumferential surface of the cover.

For example, the first sealing region 51B can be made of a two-component sealing material, and the second sealing region 52B and the third sealing region 53B can be made of an insulating tape. The workability in the sealing step can be facilitated. Alternatively, for example, a sealing material having a relatively short curing time may be used for the first sealing region 51B, and a sealing material having a relatively long curing time may be used for the second sealing region 52B and the third sealing region 53B. When the second and third sealing regions 52B and 53B, which are easy to visually check, are cured, it can be determined that the first sealing region 51B is also cured, and thus the workability in the sealing step can be streamlined. As described above, materials suitable for respective purposes can be used. Preferably, the first sealing region 51B is made of a material having a high sealability, and the second sealing region 52B and the third sealing region 53B are made of a material which is thin in thickness and can prevent the spread of rust.

The electronic device 20B described above achieves predetermined effects of the invention.

The electronic device according to the invention has been described using an example in which the electronic device is mounted in the equipment placement room 12 formed in front of the passenger compartment 11 configured to accommodate a passenger. However, the electronic device may be also applied to a case in which the electronic device is mounted in an equipment placement room formed in the rear of or below the passenger compartment 11.

A vehicle in which the electronic device is mounted is not limited to a vehicle driven by an engine, but may be an electric vehicle or a hydrogen vehicle.

An aluminum alloy is used as an example of a material of the housing and the cover, but any metals such as an SUS material can be selected. In addition, different materials may be selected for the housing and the cover.

In the sealing step, the sealing material 62 leaked out from between the housing 30 and the cover 40 by being sandwiched is pressed against the outer circumferential surfaces of the housing 30 and the cover 40 and left until cured. However, the sealing material 62 is not necessarily left until cured. Technically, the sealing material 62 is gradually cured by a chemical reaction. Therefore, the sealing material 62 may be pressed against the outer circumferential surfaces of the housing 30 and the cover 40 while the sealing material 62 has a certain fluidity before being cured, and the pressing against the outer circumferential surfaces may be released after the fluidity is lost even when the sealing material 62 is not yet cured. In that case, the work time in the sealing step can be shortened.

When the electronic device 20A is an electric compressor, the opening 31 provided in the housing 30 may be opened, not at the upper surface, but toward a front-rear direction or a right-left direction. Further, the housing 30 may have a shape other than a substantially cuboid shape. The internal space Sp is formed with a circuit board accommodation internal space (not illustrated) and a refrigerant compressing internal space (not illustrated) which is partitioned separately from the circuit board accommodation internal space and configured to suck and compress a refrigerant.

The housing 30 and the cover 40 of the electronic device 20A may be fastened outside the first sealing region 51 with some fastening members (bolts or the like). In that case, the second sealing region 52 and the third sealing region 53 are continuous with end portions of the first sealing region 51 between the fastening members. At the portions at which the fastening members are provided, the second sealing region 52 is provided on the outer circumference of the opening 31 of the housing 30 on an outer side of the fastening members, and the third sealing region 53 is provided on the outer circumference of a leading end of the cover side surface portion 42 on an outer side of the fastening members. In this situation, the second sealing region 52 and the third sealing region 53 are not continuous with the end portions of the first sealing region 51 at the portions at which the fastening members are provided.

As described above, even when there are portions at which the second sealing region 52 and the third sealing region 53 are not continuous with the end portions of the first sealing region 51, a sufficiently long distance can be secured from the outer surface of the electronic device 20 to the internal space Sp at the portions at which the fastening members are interposed between the second sealing region 52 and the first sealing region 51 and between the third sealing region 53 and the first sealing region 51. As described above, the second sealing region 52 and the third sealing region 53 are not necessarily continuous over the entire circumference of the electronic device with the end portions of the first sealing region 51.

The invention is not limited to Examples as long as the actions and effects of the invention are achieved.

### Industrial Applicability

The electronic device according to the invention is suitable for being mounted in an equipment placement room of a passenger vehicle.

### Reference Signs List

11: Passenger compartment
12: Equipment placement room
20, 20A, 20B: Vehicular electronic device
22: Circuit board
30: Housing
31: Opening
40: Cover
50, 50B: Sealing member
51, 51B: First sealing region
52, 52B: Second sealing region
53, 53B: Third sealing region
Sp: Internal space

## Claims

1. A vehicular electronic device provided in an equipment placement room (12) partitioned separately from a passenger compartment (11) configured to accommodate a passenger, the vehicular electronic device comprising:
a housing (30) made of metal and formed with an internal space (Sp) including an opening (31);
a circuit board (22) accommodated in the internal space (Sp) and configured to be energized;
a cover (40) made of metal and configured to cover the opening (31); and
a sealing member (50; 50B) sandwiched between the housing (30) and the cover (40) and configured to prevent dust from entering into the internal space (Sp),
the sealing member (50; 50B) including
a first sealing region (51; 51B) formed over an entire circumference so as to be sandwiched between an edge of the opening (31) and an edge of the cover (40),
a second sealing region (52; 52B) formed so as to be continuous from an end portion of the first sealing region (51; 51B) and adhered to an outer circumferential surface of the housing (30), and
a third sealing region (53; 53B) formed so as to be continuous from an end portion of the first sealing region (51; 51B) and adhered to an outer circumferential surface of the cover.

2. The vehicular electronic device according to claim 1, wherein the first sealing region (51), the second sealing region (52), and the third sealing region (53) are integrally formed of a single member.

3. The vehicular electronic device according to claim 1 or 2, wherein a thickness of the second sealing region (52; 52B) and/or a thickness of the third sealing region (53; 53B) are/is thinner than a thickness of the first sealing region (51; 51B).

4. A method for producing a vehicular electronic device, the vehicular electronic device being provided in an equipment placement room (12) and operated by being energized, the equipment placement room (12) being partitioned separately from a passenger compartment (11) configured to accommodate a passenger, the method comprising:
a preparation step of preparing
a housing (30) made of metal and formed with an internal space (Sp) including an opening (31),
a circuit board (22) configured to be energized, and
a cover (40) made of metal;
a circuit board accommodation step of accommodating the circuit board (22) in the internal space (Sp), the circuit board accommodation step being a step after the preparation step;
a sealing material application step of applying a sealing material to an edge of the opening (31) and/or an edge of the cover (40), the sealing material application step being a step after the circuit board accommodation step;
a sealing material sandwiching step of sandwiching the sealing material (62) between the edge of the opening (31) and the edge of the cover (40) caused to face each other, the sealing material sandwiching step being a step after the sealing material application step; and
a sealing step of performing sealing by pressing the sealing material (62) protruded from between the edge of the opening (31) and the edge of the cover (40) in the sealing material sandwiching step against outer circumferential surfaces of the housing (30) and the cover (40) .

5. The method for producing a vehicular electronic device according to claim 4, further comprising a plasma surface treatment step of irradiating the edge of the opening (31) and the edge of the cover (40) with plasma before the circuit board accommodation step.
